# EUROPÄISCHE PATENTSCHRIFT

(11) **EP 0 491 020 B1**
(45) Veröffentlichungstag und Bekanntmachung des Hinweises auf die Patenterteilung: **06.10.1993**
(21) Anmeldenummer: 91912126.9
(22) Anmeldetag: 22.06.1991
(51) Int. Cl.: C23F 1/34, C23F 1/46

(54) **ÄTZLÖSUNG**
ETCHING SOLUTION
SOLUTION DE GRAVURE

(30) Priorität: 05.07.1990 AT 1433/90
(43) Veröffentlichungstag der Anmeldung: 24.06.1992
(73) Patentinhaber: ELO-CHEM Ätztechnik GmbH, D-88709 Meersburg (DE)
(72) Erfinder: LINDINGER, Bernd, A-3021 Pressbaum (AT)
(74) Vertreter: Riebling, Peter, Dr.-Ing.
(86) Internationale Anmeldenummer: EP9101159
(87) Internationale Veröffentlichungsnummer: WO9201086

(56) Entgegenhaltungen:
- DE-A- 2 625 869
- DE-A- 3 305 319
- FR-A- 2 101 897
- GB-A- 2 163 101

## Beschreibung

Die Erfindung hat die Beschleunigung der Ätzgeschwindigkeit bei der Auflösung von Kupfer- und Kupfer-Legierungen zum Gegenstand. Im besonderen betrifft die Erfindung die Beschleunigung von alkalischen Ätzmitteln, wie sie in der Leiterplattenfertigung verwendet werden.

In der Leiterplattenfertigung geht man in der Regel von kupferkaschiertem Basismaterial aus. Die gewünschten Leiterbahnzüge werden derart erzeugt, daß das Leiterbahnbild mittels Siebdruck oder mittels eines Photoprozesses auf die Kupferoberfläche als Resistbild aufgebracht wird. Die vom Resist unbedeckte Kupfer-Oberfläche wird durch geeignete Ätzmittel aufgelöst.

Ein anderes Verfahren, wie es bei zweiseitigen Leiterplatten verwendet wird, bedruckt die später wegzuätzende Oberfläche, läßt also Leiterbahnzüge und Durchkontaktierungen frei. In der Folge werden die Leiterbahnen galvanisch verstärkt, die Bohrungen galvanisch mit Kupfer beschichtet und über beides ein metallischer Resist galvanisch abgeschieden (sn, Sn/Pb-Metallresiste). Anschließend wird der zu Beginn aufgebrachte organische Resist gestrippt und das darunter liegende Kupfer wird durch ein geeignetes Ätzmittel aufgelöst. Die Leiterbahnen und Durchkontaktierungen sind durch den Metallresist vor der Auflösung geschützt.

Während zur Fertigung einseitiger Leiterplatten saure Ätzmittel verwendet werden, so macht die angewandte Metallresisttechnik bei der Fertigung durchkontaktierter Leiterplatten die Verwendung alkalischer Ätzmittel notwendig. Als optimales Ätzmittel hat sich das Kupfertetramminchlorid durchgesetzt, das neben ausreichender Ätzrate kaum Hinterätzung zeigt, den Metallresist nicht wesentlich angreift und ein hohes Kupfer-Aufnahmevermögen aufweist.

Nachteile dieses bekannten Ätzverfahrens sind, daß das abgeätzte Kupfer nur in sehr aufwendiger Weise zurückgewonnen werden kann, was vom Anwender praktisch nicht vorgenommen werden kann und somit die verbrauchte Lösung entsorgt werden muß. Dies kann durch teure Entgiftung des komplexen Kupfertetramminchlorids geschehen, oder, für den Anwender einfacher, durch Zurücknahme der verbrauchten Lösung durch den Hersteller. Im EG-Bereich allein werden derart mehr als 6 Mill. Liter Ätzmittel jährlich auf den Straßen transportiert. Die Gefährdung ist offensichtlich.

Gelöst konnte das Problem erst mit der Entwicklung eines Ätzmittels auf Sulfatbasis werden, aus dem das gelöste Kupfer elektronisch abgeschieden werden kann, also wiedergewinnbar ist. Das Ätzmittel kann hierbei zwischen Ätzanlage und Recyclinganlage im Kreis geführt werden und braucht, abgesehen von den Verlusten, nicht erneuert werden. Das zurückgewonnene Kupfer kann mit Gewinn verkauft werden.

Demgegenüber steht der Nachteil des Kupfertetramminsulfat-Ätzmittels, das im Vergleich zum Kupfertetramminchlorid eine um etwa 30% geringere Ätzrate hat, was längere Ätzzeiten und damit geringeren Produktionsausstoß bedeutet. Dieser Mangel kann durch längere Ätzmodule ausgeglichen werden oder durch Einsatz eines Beschleunigers, der die Ätzrate deutlich erhöht.

Eine solche Beschleunigung ist Ziel der vorliegenden Erfindung.

Die hierbei eingesetzten Ätzlösungen bestehen üblicherweise aus Tetramminkupfer(II)-sulfat, Ammoniak, Ammonsulfat und Ammonchlorid oder aus Salzen entsprechender Ionen. Ätzlösungen ohne Halogenide entsprechen ebenfalls dem beschriebenen Verfahren. Ein weiterer Zusatz zur Verhinderung der Oxidation des Pb/Sn- oder Sn-Ätzresistes und zur Passivierung der Anodenseite der bipolaren Elektroden ist Phosphorsäure oder ein lösliches Phosphat. Auch Formulierungen, die einen Teil des Sulfats durch Nitrat ersetzen, können erfindungsgemäß beschleunigt werden.

Die vorstehend beschriebenen bekannten Formulierungen erreichen eine Ätzgeschwindigkeit von etwa 30 bis 35 µm Kupfer/min.

Erfindungsgemäß kann die Ätzgeschwindigkeit derartiger Ätzlösungen durch genau dosierte Zugabe von Vanadium, Vanadaten oder anderen Vanadiumsalzen katylsiert werden, so daß eine wesentliche Beschleunigung der Ätzgeschwindigkeit auf etwa 40 bis 50 µm Kupfer/min. erreicht werden kann.

Gegenstand der vorliegenden Erfindung ist somit eine elektrolytische regenerierbare Ätzlösung zur Ätzung von Leiterplatten und Formteilen aus Kupfer und Kupfer-Legierungen, mit einem Gehalt an Kupfertetramminsulfat, Ammoniak, Ammonsulfat, Ammonchlorid, gegebenenfalls Ammonnitrat, sowie an einem die Ätzgeschwindigkeit erhöhenden Katalysator. Erfindungsgemäß zeichnet sich eine derartige Ätzlösung durch ein Gehalt an Vanadium oder einer Vanadiumverbindung als Katalysator in einer Menge von 1 mg bis 99 mg/l Ätzlösung, berechnet als Vanadium, aus.

### Beispiele für erfindungsgemäße Ätzlösungen sind:

- 1. Lösung:: 60..- 120 g Cu/l
150..- 200 g SO₄/l
0,5- 5 k Cl/l
1 - 99 mg V/l
- 2. Lösung: 60. - 20 g Cu/l
120 - 170 g SO₄/l
10 - 100 g NO₃/l
0,5- 5 g Cl/l
1 - 99 mg V/l
- 3. Lösung: 60 - 120 g Cu/l
120 - 170 g SO₄/l
10 - 100 g NO₃/l
0,5- 5 g Cl/l
0,5- 20 g PO₄/l
1- 99 mg V/l

Die Lösung 1 bis 3 enthalten zusätzlich Ammoniak zur Einstellung des alkalischen pH-Wertes.

In bekannter Weise ist die Ätzgeschwindigkeit temperatur- und pH-Wertabhängig. Als optimal wurden für die erfindungsgemäße Ätzlösung Temperaturen von 35°C bis 60°C ermittelt, bei einem pH-Wert von 8,1 bis 8,8.

Vanadium bzw. Vanadiumverbindungen sind als Katalysatoren für Ätzlösungen auf der Basis von Kupfertetramminsulfat an sich bereits bekannt (DE-A1 33 05 319). Die darin vorgeschriebenen Formulierungen fanden aber keine Verbreitung in der Praxis, da den beschriebenen Ätzlösungen gravierende Mängel anhafteten.

So fordert die DE-A1 33 05 319 eine absolute Halogenfreiheit, wenn für die eingesetzte Ätzlösung als charakteristisch herausgestellt wird, daß sie SO₄-Ionen enthält und Cl-frei ist.

Eine derartige, als nicht sinnvoll erkannte Forderung wird von der vorliegenden Erfindung nicht gestellt.

Besonders unbefriedigend sind jedoch die gemäß DE-A1 33 05 319 erzielten Kupfer-Abscheidungen in den Recyclinganlagen. Zum einen, weil die Kupferabscheidungen zu spröde waren, zum anderen, weil sie nicht fest zusammenhängend waren, zum Zerbröseln neigten und letztlich von der Kathode schwer abzuernten waren (siehe DE-A1 34 29 902 und das nachfolgende Vergleichsbeispiel).

Diesem Mangel wird in der vorliegenden Erfindung dadurch begegnet, daß die Vanadium-Konzentration lediglich im Bereich von 1 mg/l bis 99 mg/l gehalten wird, so daß das im Kupfer mit abgeschiedene Vanadium nur in geringster Konzentration (10 µg/g) vorhanden ist und daher weder eine Versprödung noch eine Zerbröselung der Kupfer-Kathoden bewirkt.

Der Ätzprozeß genügt, vereinfacht dargestellt, der folgenden Gleichung:

Cu + Cu++ ₂ _{Cu}+

Die Rückoxidation des Cu⁺ zu Cu⁺⁺ erfolgt durch Luftsauerstoff. Da die Ätzgeschwindigkeit von der Konzentration der Cu⁺⁺ -Ionen abhängt, wird diese durch die Geschwindigkeit der Rückoxidation mitbestimmt, die wieder ätzmaschinenabhängig sehr variieren kann (Luftzufuhr, Sprühdruck usw.).

Die Erfindung wird in dem nachfolgenden Beispiel näher erläutert:

### BEISPIEL:

Eine Ätzlösung mit einem Gehalt von 330 g CuSO₄. 5H₂O, 80 g Ammonsulfat, 4 gAmmonchlorid, 90 mg V₂O₅ und 4 g (NH₄)₂ HPO₄ , jeweils pro Liter, deren pH-Wert mit Ammoniak auf 8,4 eingestellt war, wurde in einem Ätzmodul bei einer Arbeitstemperatur von 50°C zum Abätzen von einseitig Cu-kaschierten Leiterplatten und von durchkontaktierten Leiterplatten verwendet. In kontinuierlichem Betrieb wird eine Ätzgeschwindigkeit von etwa 40 µm Kupfer/min. erreicht.

Bei der elektrolytischen Regeneration wird das Kupfer kathodisch abgeschieden und kann leicht von der Kathode als zusammenhängende Folie abgezogen werden.

### VERGLEICHSBEISPIEL (entsprechend DE-A1 33 05 319)

Die Lehre der DE-A1 33 05 319 wurde anhand der darin geoffenbarten "optimalen Zusammensetzung" nachgearbeitet. Diese Ätzlösung enthielt je Liter 0,787 Mol Kupfertetramminsulfat, 0,45 Mol Ammonsulfat, 0,45 Mol Ammoniak und 1 g Ammoniummonovanadat. Der pH-Wert betrugt 9,65. Beim Ätzversuch an kupferkaschierten Leiterplatten konnten im wesentlichen die in der DE-A1 33 05 319 angeführten Ätzgeschwindigkeiten erreicht werden. In der anschließenden elektrolytischen Regenerierung der Ätzlösung konnten hingegen keine zusammenhängenden Kupferniederschläge erhalten werden; das abgeschiedene Kupfer hängt nicht fest zusammen, neigt zum Zerbröseln und läßt sich nur schlecht von der zur Abscheidung verwendeten Elektrode ablösen.

## Patentansprüche

1. Elektrolytisch regenerierbare Ätzlösung zur Ätzung von Leiterplatten und Formteilen aus Kupfer und Kupfer-Legierungen, mit einem Gehalt an Kupfertetramminsulfat, Ammoniak, Ammonsulfat, Ammonchlorid, gegenebenfalls Ammonnitrat, sowie an einem die Ätzgeschwindigkeit erhöhenden Katalysator, **dadurch gekennzeichnet,** daß die Ätzlösung als Katalysator Vanadium oder eine Vanadiumverbindung in einer Menge von 1 mg bis 99 mg/l Ätzlösung, berechnet als Vanadium, enthält.

2. Ätzlösung nach Anspruch 1, **dadurch** **gekennzeichnet,** daß sie pro Liter 1 bis 2 Mol Kupfer, 0,01 bis 0,1 Mol Ammonchlorid, 0,1 bis 1,3 Mol Ammonnitrat, 1,8 bis 2,1 Mol Ammonsulfat sowie eine zur Einstellung des pH-Wertes auf 8,1 bis 8,8 ausreichende Menge Ammoniak enthält.

3. Ätzlösung nach Anspruch 1 oder 2, **dadurch** **gekennzeichnet,** daß sie pro Liter 330 g CuSO₄.5 H₂O, 80 g Ammonsulfat, 4 g Ammonchlorid, 4 g (NH₄)₂ HPO₄, 90 mg V₂O₅ und eine zur Einstellung des PH-Wertes auf 8,4 ausreichende Menge Ammoniak enthält.

4. Ätzlösung nach einem der Ansprüche 1 bis 3, **dadurch** **gekennzeichnet,** daß sie 0,1 bis 20 g je Liter Phosphat in Form von Phosphorsäure oder einem Phosphorsäuresalz enthält.

## Claims

1. An electrolytically regenerable etching solution for the etching of printed circuit boards and shaped parts of copper and copper alloys, with a content of copper tetrammine sulphate, ammonia, ammonium sulphate, ammonium chloride, if necessary ammonium nitrate, and also of a catalyst which increases the etching speed,
characterised in that
the etching solution contains as catalyst vanadium or a vanadium compound in a quantity of 1 mg to 99 mg/l etching solution, calculated as vanadium.

2. An etching solution according to Claim 1,
characterised in that
it contains per litre 1 to 2 mol copper, 0.01 to 0.1 mol ammonium choride, 0.1 to 1.3 mol ammonium nitrate, 1.8 to 2.1 mol ammonium sulphate and a quantity of ammonia sufficient to set the pH value at 8.1 to 8.8.

3. An etching solution according to Claim 1 or 2,
characterised in that
it contains per litre 330 g CuSO₄.5 H₂O , 80 g ammonium sulphate, 4 g ammonium chloride, 4 g (NH₄₋) HPO₄₋, 90 mg V₂O₅ and a quantity of ammonia sufficient to set the pH value at 8.4.

4. An etching solution according to one of Claims 1 to 3,
characterised in that
it contains 0.1 to 20 g per litre phosphate in the form of phosphoric acid or a phosphoric acid salt.

## Revendications

1. Solution décapante apte à être régénérée par voie électrolytique pour la gravure de cartes à circuits imprimés et de pièces profilées en cuivre et en alliages de cuivre, contenant du sulfate de cuivre tétramine, de l'ammoniac, du sulfate d'ammonium, du chlorure d'ammonium, éventuellement du nitrate d'ammonium, ainsi qu'un catalyseur augmentant la vitesse de gravure, caractérisée en ce que la solution décapante contient, comme catalyseur, du vanadium ou un composé de vanadium en une quantité de 1 mg à 99 mg/l de solution décapante, exprimée en vanadium.

2. Solution décapante selon la revendication 1, caractérisée en ce qu'elle contient, par litre, 1 à 2 moles de cuivre, 0,01 à 0,1 mole de chlorure d'ammonium, 0,1 à 1,3 moles de nitrate d'ammonium, 1,8 à 2,1 moles de sulfate d'ammonium et une quantité d'ammoniac suffisante pour obtenir un pH de 8,1 à 8,8.

3. Solution décapante selon la revendication 1 ou 2, caractérisée en ce qu'elle contient, par litre, 330 g de CuSO₄.5 H₂O, 80 g de sulfate d'ammonium, 4 g de chlorure d'ammonium, 4 g de (NH₄)₂ HPO₄, 90 mg de V₂O₅ et une quantité d'ammoniac suffisante pour obtenir un pH de 8,4.

4. Solution décapante selon l'une des revendications 1 à 3, caractérisée en ce qu'elle contient 0,1 à 20 g par litre de phosphate sous la forme d'acide phosphorique ou d'un sel d'acide phosphorique.
